Europäisches Patentamt

European Patent Office

Office européen des brevets

(11) Veröffentlichungsnummer: **0 608 448 A1**

(12) **EUROPÄISCHE PATENTANMELDUNG**

(21) Anmeldenummer: **93101145.6**

(22) Anmeldetag: **26.01.93**

(51) Int. Cl.⁵: **G03F 9/00**, G02B 21/24,
G01B 11/02

(43) Veröffentlichungstag der Anmeldung:
**03.08.94 Patentblatt 94/31**

(84) Benannte Vertragsstaaten:
**DE FR GB**

(71) Anmelder: **International Business Machines
Corporation
Old Orchard Road
Armonk, N.Y. 10504(US)**

(72) Erfinder: **Wagner, Dietmar
Sechselberger Strasse 23
W-7000 Stuttgart 50(DE)**

(74) Vertreter: **Mönig, Anton, Dipl.-Ing.
IBM Deutschland Informationssysteme
GmbH,
Patentwesen und Urheberrecht
D-70548 Stuttgart (DE)**

(54) **Verfahren und Vorrichtung zur Positionsbestimmung.**

㊾ Die Erfindung betrifft ein Verfahren sowie eine Vorrichtung zur schnellen und präzisen Bestimmung der Lage eines Objekts (1) bezüglich der Gegenstandsebene (2) eines Objektivs (3). Dazu wird die Austrittsöffnung zumindest einer lichtleitenden Faser (6, 61, 62) vertikal verschiebbar im Bereich der Bildebene (4) der Objektivlinse angeordnet. Durch die Faser (bzw. Fasern) geführtes Licht einer Lichtquelle (11) (bzw. mehrerer Lichtquellen) wird über die Objektivlinse (3) auf die Oberfläche des Objekts (1) projiziert. Das von der Oberfläche reflektierte Licht fällt über das Objektiv in die Faser(n) zurück, so daß jede Faser gleichzeitig als Beleuchtungsquelle und Empfänger wirkt. Zur Bestimmung der Objektlage wird die reflektierte Intensität an verschiedenen Positionen der Faser (bzw. Fasern) vertikal zur Bildebene gemessen. Aus den erhaltenen Intensitätswerten läßt sich die Distanz des Objekts zur exakten Fokuslage präzise bestimmen. Die erforderlichen Berechnungen können beispielsweise über eine Prozessoreinheit automatisch erfolgen. Anschließend kann durch Ansteuerung entsprechender Justierelemente das Objekt in die Gegenstandsebene positioniert werden.

FIG. 1

Rank Xerox (UK) Business Services
(3.10/3.09/3.3.4)

Die Erfindung liegt auf dem Gebiet optischer Technik. Sie betrifft insbesondere abbildende Systeme, in denen eine automatische Fokussierung eines Objekts erfolgt. Vorgestellt wird ein Verfahren sowie eine Vorrichtung, die eine schnelle und hochpräzise Bestimmung der Lage eines Objekts bezüglich der Gegenstandsebene einer Objektivlinse ermöglicht. Das vorgestellte Verfahren sowie die entsprechende Vorrichtung kann somit für eine schnelle und automatische Fokussierung eingesetzt werden.

Optische Instrumente, bei denen eine automatische Fokuseinstellung mit möglichst großer Genauigkeit erfolgen soll, werden in zahlreichen Gebieten eingesetzt, so bei Untersuchungen (Mikroskope, Inspektions- und Meßstationen), aber auch bei der Herstellung industrieller Produkte z.B. in Form von Belichtungseinrichtungen.

Speziell moderne Halbleiterprodukte, bei denen durch optische Lithographieverfahren Strukturen im Bereich von 1 $\mu$m und kleiner definiert werden, stellen an die eingesetzten optischen Geräte höchste Anforderungen bezüglich Genauigkeit und Reproduzierbarkeit. Hohe Stückzahlen bedingen zusätzlich eine hohe Geschwindigkeit der automatisch erfolgenden Justierungen.

Das US Patent Nr. 5 073 018 (Kino et al.) beschreibt ein Mikroskop mit automatischer Fokussierung. Dabei wird das vom Objekt reflektierte Licht einer inkohärenten Lichtquelle überlagert mit dem reflektierten Licht eines Referenzspiegels. Dieser Spiegel ist aufgebaut als sehr dünne Folie, die oberhalb des Objekts angebracht ist. Die Folie ist teildurchlässig, so daß ein Teil des einfallenden Lichts das Objekt beleuchtet. Die Überlagerung der beiden reflektierten Lichtanteile liefert ein Intensitätssignal, über das z.B. mittels eines Prozessors die korrekte Fokuseinstellung bestimmt werden kann. Die Effektivität dieser Autofokuseinrichtung ist wesentlich bestimmt durch die präzise Positionierung der dünnen Folie über dem Objekt, so daß entsprechend aufwendige Halterungen und Justageelemente erforderlich sind.

Eine andere Methode für eine automatische Fokuseinstellung ist im Artikel 'Focus Detection Method for an Optical Instrument' , C. P. Kirk, IBM Technical Disclosure Bulletin Vol. 32, p. 130, (1989) dargestellt. Hierbei wird das beleuchtete Objekt vertikal zur Gegenstandsebene bewegt und der Intensitätsverlauf des reflektierten Lichts detektiert. Durch wechselndes Ausblenden eines Teils des auf das Objekt gerichteten Lichts ergeben sich unterschiedliche Intensitätsprofile aus denen über eine vergleichende Auswerteeinheit die Fokuslage berechnet werden kann. Dieses Verfahren ist relativ zeitaufwendig, da mehrere Intensitätsprofile durchlaufen und ausgewertet werden müssen.

Eine Belichtungseinrichtung für die Halbleiterproduktion mit einer Autofokuseinrichtung ist dargestellt in 'Improvements in 0.5 Micron Production Wafer Steppers', P.F. Luehrmann et al., SPIE Vol. 1463 (1991). Zur Bestimmung der Lage des Objekts bezüglich der Gegenstandsebene wird Laserlicht streifend auf die Oberfläche des Objekts gerichtet und das unter kleinem Winkel reflektierte Licht detektiert. Die Strahlführung ist dabei so ausgerichtet, daß auf dem Objekt nur ein kleines Areal direkt unterhalb der abbildenden Linse ausgeleuchtet wird. Nur dieser zentrale Bereich wird also in die Gegenstandsebene justiert, so daß bei relativ großflächigen Halbleiterprodukten Randbereiche auch geringfügig außerhalb der Gegenstandsebene liegen können. Zudem erfolgt bei dieser Anordnung die Fokusbestimmung nicht direkt durch die abbildende Linse selbst, sondern davon unabhängig durch eine separate Fokussiereinrichtung. Bei Einstellungen im Sub-Mikrometerbereich können so bereits geringfügige Differenzen zu systematischen Fehlern führen.

Der vorliegenden Erfindung liegt die Aufgabe zugrunde, eine neue, leistungsfähigere Methode und Vorrichtung für eine schnelle und hochgenaue Bestimmung der Lage eines Objekts bezüglich der Gegenstandsebene einer Objektivlinse zu entwikkeln. Insbesondere soll durch die erfindungsgemäße Positionsbestimmung eine verbesserte Autofokussierung ermöglicht werden.

Erfindungsgemäß wird dies entprechend den Ansprüchen dadurch erreicht, daß die Austrittsöffnung zumindest einer lichtleitenden Faser im Bereich der Bildebene einer Objektivlinse angeordnet ist. Durch die Faser (bzw. Fasern) geführtes Licht einer Lichtquelle (bzw. mehrerer Lichtquellen) wird dabei über die Linse auf die Oberfläche des Objekts projiziert. Das von der Oberfläche reflektierte Licht fällt über die Linse in die Faser(n) zurück, so daß jede Faser gleichzeitig als Beleuchtungsquelle und Empfänger wirkt. Die Intensität des so in eine Faser zurückgeleiteten Lichts ist offensichtlich in starkem Maße abhängig von der Lage des Objekts bezüglich der Gegenstandsebene der Linse.

Zur Bestimmung der absoluten Objektlage wird die reflektierte Intensität an verschiedenen Positionen der Faser (bzw. Fasern) vertikal zur Bildebene gemessen. Bei nur einer Faser erhält man diese Werte nacheinander durch Verschieben der Faser vertikal zur Bildebene. Bei Verwendung mehrerer Fasern, die in verschiedenen Abständen zur Bildebene angeordnet sind, ergeben sich mehrere Intensitätswerte simultan. Aus den erhaltenen Intensitätswerten läßt sich die Distanz des Objekts zur exakten Fokuslage präzise bestimmen. Die erforderlichen Berechnungen können beispielsweise über eine Auswerteeinheit automatisch erfolgen. Anschließend kann durch Ansteuerung entsprechender Justierelemente die Objektlage gezielt verändert werden. Alle Auswerte- und Steuerungsvorgänge können vorzugsweise durch ein Prozessorsystem vorgenommen werden. Damit ist eine automatische Positionsbestimmung und Korrektur der Objektlage auf vorgegebene Postionen möglich.

Weitere Aspekte und Einzelheiten der Erfindung werden im folgenden anhand spezieller Ausführungsbeispiele unter Bezugnahme auf die Zeichnungen dargelegt. Dabei zeigt

Fig. 1    eine Vorrichtung zur Positionsbestimmung mit nur einer lichtleitenden Faser;

Fig. 2A    ein Diagramm der von der Faser (Fig. 1) aufgenommenen Lichtintensität beim Verschieben der Faser vertikal zur Bildebene;

Fig. 2B    ein Diagramm des phasenempfindlich gleichgerichteten Signals von Fig. 2A;

Fig. 3    eine alternative Vorrichtung mit zwei lichtleitenden Fasern in unterschiedlichem Abstand zur Bildebene;

Fig. 4    Beispiel einer 3-Punkte-Justierung in einer Halbleiterbelichtungseinrichtung.

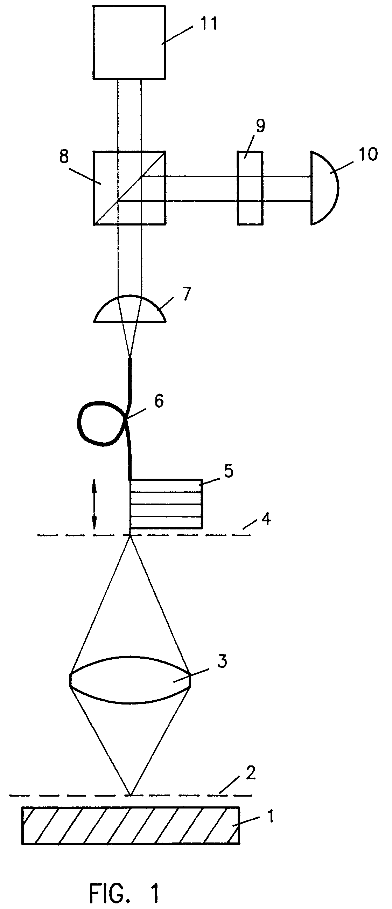

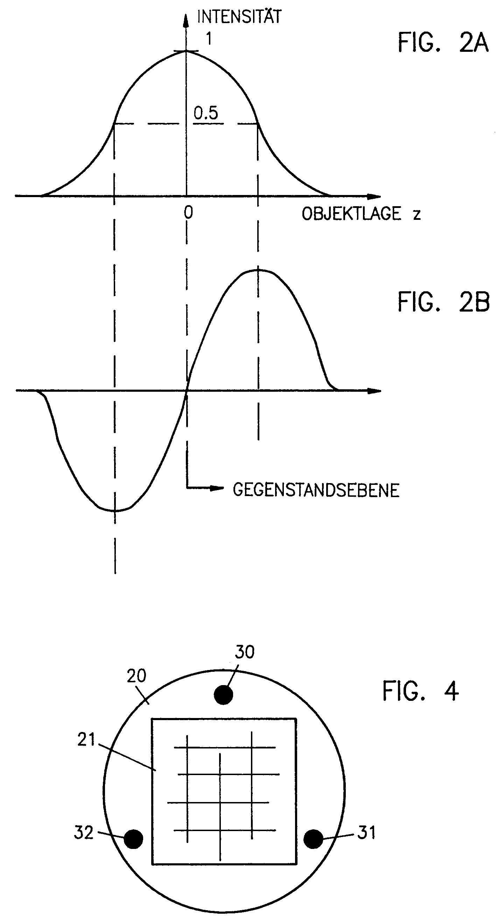

Fig. 1 zeigt ein Ausführungsbeispiel, bei dem nur eine lichtleitende Faser verwendet wird. Das Licht einer intensiven Lichtquelle 11 wird über eine Linse 7 gebündelt und in eine Faser 6 eingeleitet. Das andere Ende der Faser ist im Bereich der Bildebene 4 eines Objektivs 3 mittels einer Verstelleinrichtung 5 vertikal verschiebbar angebracht. Aus der Faser austretendes Licht beleuchtet durch die Objektivlinse 3 das Objekt 1. Das vom Objekt reflektierte Licht wird von der Objektivlinse 3 in die Faser zurückgeleitet und nach Durchlaufen der Faser über einen Strahlteiler 8 auf einen Detektor 10 gerichtet. Zur Unterdrückung unerwünschter Wellenlängen können entsprechende optische Filter 9 eingesetzt werden. Das vom Detektor generierte Signal ist der Intensität des reflektierten und am Faserende in die Faser wiedereingeleiteten Lichts proportional. Verschiebt man das Objekt 1 vertikal zur Gegenstandsebene 2, so erhält man einen Intensitätsverlauf wie in Fig. 2A dargestellt. Aufgrund des flach verlaufenden Intensitätsmaximums sind geringfügige Abweichungen der Objektposition zur Fokuslage bei direkter Intensitätsmessung nur relativ ungenau zu erfassen. Zur präzisen Bestimmung der Lage des Objekts wird daher durch eine Verstelleinrichtung 5 der Abstand des Faserendes zur Bildebene periodisch um einen geringen Betrag variiert. Die Amplitude der Faseroszillation $\Delta z$ sollte den Wert

$$\Delta z \approx \frac{\lambda}{(N.A.)^2}$$

nicht übersteigen.

N.A. = Numerische Apertur

Bei Einsatz eines Piezoschwingers kann dieser beispielsweise direkt von einem Spannungsgenerator (nicht dargestellt) angesteuert werden. Wird nun das detektierte Intensitätssignal in Abhängigkeit von der Schwingungsphase des Spannungsgenerators verstärkt (Lock-In-Technik), so erhält man bei Verschiebung des Objekts das in Fig. 2.b schematisch dargestellte Signal. Dieses Signal weist einen steilen Nulldurchgang auf, so daß die exakte Lage des Objekts im Bereich der Gegenstandsebene 2 sehr genau erfaßt werden kann. Da bei größerer Entfernung des Objekts von der Gegenstandsebene 2 die detektierte Lichtintensität schnell gegen den Wert Null geht, d.h. zu gering für eine Auswertung ist, sollte eine Positionsbestimmung und Lagekorrektur des Objekts vorzugsweise im Bereich der Schärfentiefe der Objektivlinse vorgenommen werden.

Die Gegenstandsebenen-Einstellung läßt sich mit einer Regelung (closed loop) erreichen. Nur mit Hilfe der Regelung lassen sich Nichtlinearitäten und Hysterese des Systems ausschalten.

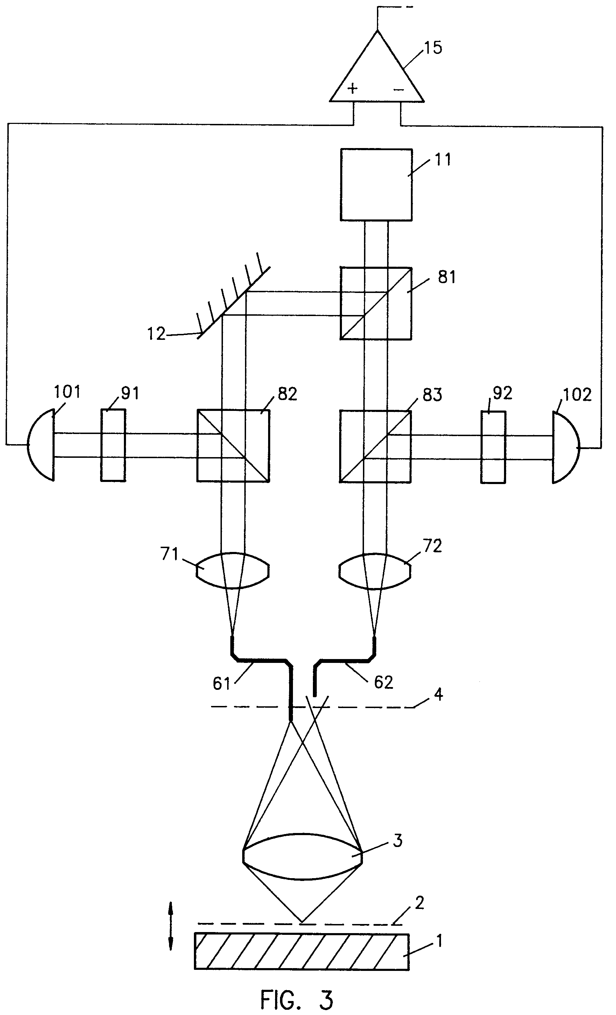

Ein alternatives Ausführungsbeispiel ist in Fig. 3 dargestellt. Diese Anordnung kommt durch Verwendung mehrerer optischer Fasern ohne Lock-In Technik aus. Statt einer Oszillation einer Faser werden zwei Fasern 61, 62 in geringem Abstand von z.B.

$$\pm \frac{\lambda}{2(N.A.)^2}$$

von der Bildebene 4 angebracht. Das vom Objekt reflektierte Licht wird von diesen Fasern in der beschriebenen Weise aufgenommen und individuell über Strahlteiler 82, 83 auf separate Detektoren 101, 102 geleitet. Auch in dieser Anordnung können optische Filter 91, 92 zur Unterdrückung bestimmter Lichtwellenlängen eingesetzt werden. Zur Ausleuchtung des Objekts wird in der bevorzugten Ausführung das Licht einer Lichtquelle 11 über einen Strahlteiler 81 und einen Reflektor 12 in zwei Anteile getrennt, die durch Linsen 71, 72 in die Fasern 61, 62 gebündelt werden. Für eine bestimmte Objektlage erhält man mit dieser Anordnung zwei Signale von den Detektoren 101 und 102. Diese Signale werden nun in der aufnehmenden Verstärkereinheit 15 voneinander subtrahiert und das so erhaltene Differenzsignal zur Auswertung herangezogen. Jede unterschiedliche Objektposition erzeugt so ein entsprechendes Differenzsignal. Für verschiedene Objektlagen ergibt sich dabei ein Verlauf des Differenzsignals, der in seiner Charakteristik vergleichbar zu dem in Fig. 2.B wiedergegebenen - mit Lock-In Technik erhaltenen -Kurvenverlauf ist. Eine präzise Positionsbestimmung kann daher direkt durch Auswertung des Differenzsignals erfolgen. Der Vorteil dieses Verfahrens besteht darin, daß aufwendige Komponenten z.B. für eine Faseroszillation entfallen. Alle eingesetzten Elemente sind Standardkomponenten optischer Technik, die weitgehend auch in Miniaturausführung verfügbar sind. Bei einer in Mikrotechnik ausgeführten Anordnung nach Fig. 3 kann die Erzeugung des Differenzsignals bereits innerhalb des jeweiligen optischen Instruments erfolgen.

Beide vorgestellten Verfahren und Anordnungen haben den Vorteil, daß für eine Justierung des Objekts 1, z.B. in die Gegenstandsebene 2, nicht nur der jeweilige Betrag, sondern auch die Richtung der erforderlichen Verstellung aus dem gemessenen Signal (Fig. 2.B) direkt abgeleitet werden kann. Der Verstellvorgang erfolgt daher sofort in die richtige Richtung, was den Justiervorgang entsprechend beschleunigt.

In vielen Fällen weist das Objekt keine gut reflektierende Oberfläche auf. Beispielsweise ist bei Lithographieprozessen i.a. auf die Oberfläche eine mehr oder weniger transparente Lackschicht aufgebracht. Das erfindungsgemäße Verfahren ermöglicht eine präzise Einstellung dieser Lackschicht zur Gegenstandsebene des Objektivs. Dazu wird zur Beleuchtung des Objekts Licht mit einer Wellenlänge verwendet, die die Lackschicht zur Fluoreszenz anregt. Durch Einsetzen optischer Filter 9 werden nur die Lichtanteile detektiert, die von der Lackschicht emittiert werden. Die auf diese Weise erhaltenen Intensitätswerte und -verläufe entsprechen (qualitativ) den für reflektierende Oberflächen in Fig. 2A und 2B wiedergegebenen, wobei als Fokuslage die Einstellung der Gegenstandsebene in die Mitte der Lackschicht zu setzen ist.

Die hohe Empfindlichkeit des vorgestellten Verfahrens beruht u.a. auf der Anwendung von Fasern als Lichtgeber und -Empfänger. Um eine gute Ausleuchtung des Objekts und eine möglichst optimale Aufnahme des reflektierten Lichts zu erreichen, ist der Durchmesser der verwendeten Faser in der Bildebene dem Auflösungsvermögen der Linse in der Objektebene anzupassen. Aufgrund ihres geringen Querschnitts realisieren optische Fasern zum einen eine nahezu punktförmige Quelle, zum anderen wirken sie für das reflektierte Licht als Empfänger mit einer extrem kleinen Empfangsfläche. Geringe Abweichungen der Faser von der Bildebene bzw. Verschiebungen des Objekts aus der Gegenstandsebene bewirken daher sofort starke Intensitätsänderungen.

Die maximal detektierbare Intensität ist natürlich abhängig von der Leistung der verwendeten Lichtquelle 11. Bei Verwendung mehrerer Fasern können entweder mehrere unabhängige Lichtquellen verwendet werden, oder wie in Fig. 3 dargestellt über einen oder mehrere Strahlteiler entsprechende Lichtanteile auf verschiedene Fasern gerichtet werden. Die Verwendung nur einer Lichtquelle hat dabei den Vorteil, daß keine Intensitätsschwankungen zwischen verschiedenen Fasern auftreten können. Aufgrund der hohen Leuchtdichte sind insbesondere Laser geeignet, aber auch andere leistungsstarke Quellen wie z.B. Hg-Hochdrucklampen können eingesetzt werden. Durch Kontrolle der Lichtleistung der Quelle 11, beispielsweise durch einen zusätzlichen Photodetektor (nicht dargestellt), lassen sich eventuell vorhandene geringe Schwankungen in der Lichtleistung der Lichtquelle 11, die zu Fehlmessungen führen könnten, korrigieren. Entsprechend können auch die Lichtleistungen mehrerer Lichtquellen überwacht werden.

Die Verwendung von lichtleitenden Fasern bietet neben den beschriebenen Vorzügen den Vorteil, daß aufgrund des geringen Querschnitts solcher Fasern das Gesichtsfeld des Objektivs nahezu vollständig verfügbar bleibt, da sich im kritischen Bereich der Bildebene des Objektivs nur ein oder mehrere sehr kleine Faserenden befinden. So liegt z.B. bei einer modernen optischen Monomode-Fiber der Durchmesser typisch im Mikrometerbereich. Alle anderen Komponenten mit größerem Platzbedarf (Lichtquelle, Strahlteiler, Filter, Detektoren, Auswerte- und Steuersyteme) können in Distanz zum Objektiv 3 oder bei Bedarf auch gänzlich außerhalb des gesamten Instruments angeordnet werden. Die Positionsbestimmung kann somit direkt durch das Objektiv des jeweiligen Instruments erfolgen.

Zumeist ist bei Lithographieprozessen auf dem Objekt nicht das gesamte Gesichtsfeld mit dem Abbild einer Struktur ausgeleuchtet. Die verbleibende Fläche im Gesichtsfeld kann dann zur Positionsbestimmung nach dem erfindungsgemäßen Verfahren genutzt werden. Das ermöglicht beispielsweise in einem Halbleiter-Lithographieprozess parallel die Belichtung eines Wafers mit einer abzubildenden Chipstruktur bei simultan durch das Objektiv erfolgender Kontrolle der Waferlage. Eine schematische Darstellung ist in Fig. 4 wiedergegeben. Neben der abgebildeten Chipstruktur 21 sind innerhalb des kreisförmigen Gesichtsfeldes 20 genügend freie Flächen vorhanden, um an verschiedenen Positionen 30, 31, 32 Lagebestimmungen nach dem erfindungsgemäßen Verfahren durchzuführen, ohne den Belichtungsvorgang zu stören.

**Patentansprüche**

1. Verfahren zur Positionsbestimmung eines Objekts (1) bezüglich der Gegenstandsebene (2) einer Objektivlinse (3), wobei
   - das Objekt (1) beleuchtet und
   - mit dem vom Objekt (1) reflektierten Licht zumindestens ein Detektor (10,101,102) beaufschlagt wird,

   dadurch gekennzeichnet,
   - daß das Objekt über jeweils ein offendes Ende von mindestens einer lichtleitenden Faser (6,61,62) durch die Objektivlinse (3) hindurch beleuchtet wird,
   - daß die Intensität des am Objekt (1) reflektierten und wieder durch die Objektivlinse (3) gegangene und über das offene Ende von mindestens einer lichtleitenden Faser (6, 61, 62) aufgenommene Licht an verschiedenen Positionen einer lichtleitenden Faser bezüglich der Bildebene (4) gemessen wird und
   - daß aus den erhaltenen Intensitätsmesswerten die Distanz des Objekts zur Gegenstandsebene (2) bestimmt wird.

2. Verfahren nach Anspruch 1, dadurch gekennzeichnet, daß jeweils das offene Ende der Faser bzw. Fasern (6,61,62) einen im Vergleich zur Brennweite der Objektivlinse (3) geringen Abstand zur Bildebene (4) der Objektivlinse (3) aufweist.

3. Verfahren nach Anspruch 1 oder 2, dadurch gekennzeichnet, daß das reflektierte Licht nach der Reflektion am Objekt (1) nach dem Durchgang durch die Objektivlinse (3) jeweils am offenen Ende der lichtleitenden Faser bzw. Fasern (6,61,62) aufgenommen wird und die Faser bzw Fasern (6,61,62) auf dem Weg zum beaufschlagten Detektor (10,101,102) durchläuft.

4. Verfahren nach einem der Ansprüche 1 bis 3, dadurch gekennzeichnet, daß das Objekt (1) mittels zumindestens einer Positioniereinrichtung bezüglich der Gegenstandsebene der Objektivlinse (3) positioniert wird.

5. Verfahren nach einem der Ansprüche 1 bis 4, wobei zur Messung der Intensität des von der (den) Faser(n) aufgenommenen reflektierten Lichts an unterschiedlichen Positionen der Faser(n) bezüglich der Bildebene jede Faser mittels einer Verstelleinrichtung (5) periodisch vertikal zur Bildebene verschoben wird und so oszillierend verschiedene Abstände zur Bildebene aufweist.

6. Verfahren nach Anspruch 3, wobei die von einer Faser aufgenommene und anschließend detektierte Intensität mit der Oszillation der Positionsverstellung dieser Faser im Sinne einer Phasengleichrichtung korreliert wird.

7. Verfahren nach Anspruch 5 oder 6, wobei der Betrag der Positionsverschiebung einer Faser vertikal zur Bildebene einen Wert $\Delta z$ nicht übersteigt, der sich aus der numerischen Apertur NA der Objektivlinse und einer Wellenlänge $\lambda$ des zur Beleuchtung verwendeten Lichts ergibt zu

$$\Delta z \approx \frac{\lambda}{(N.A.)^2}$$

8. Verfahren nach einem der Ansprüche 1 bis 4, wobei mindestens zwei Fasern (61, 62) in unterschiedlicher Lage zur Bildebene angeordnet werden, das von jeder der Fasern aufgenommene reflektierte Licht individuell detektiert wird und aus den so gleichzeitig erhaltenen zwei Intensitätswerten die Distanz des Objekts (1) zur Gegenstandsebene (2) durch Differenzbildung bestimmt wird.

9. Verfahren nach Anspruch 8, wobei die Abstände der Faserenden zur Bildebene einen Betrag von

$$\Delta z \approx \frac{\lambda}{(N.A.)^2}$$

nicht überschreiten.

10. Vorrichtung zur Positionsbestimmung eines Objekts (1) bezüglich einer vorgegebenen Referenzebene
    - mit Mitteln (11) zur Beleuchtung des Objekts (1) mit Licht,
    - mit Detektormitteln (10,101,102),
    - mit einem zumindestens aus einer Objektivlinse (3) bestehenden Objektiv,
    - mit Mitteln (6,61,62) zur Führung des Lichts von den Mitteln (11) zur Beleuchtung zum Objektiv hin, wobei die Anordnung der Vorrichtung so eingerichtet ist, daß
    - das Objekt (1) durch das Objektiv hindurch von jeweils dem Ende der Mittel (6,61,62) zur Führung des Lichts beleuchtet wird,

- die Intensität des am Objekt (1) reflektierten und wieder durch das Objektiv gegangene Licht an verschiedenen Positionen bezüglich der Bildebene (4) des Objektivs gemessen wird und mit Mitteln zur Bestimmung der Distanz des Objekts (1) zur Gegenstandsebene (2) des Objektivs.

11. Vorrichtung nach Anspruch 10, dadurch gekennzeichnet, daß die Mittel zur Führung des Lichts aus zumindestens einer lichtleitenden Faser bestehen und daß die Faser(n) jeweils ein offendes Ende aufweisen, daß einen im Vergleich zur Brennweite des Objektivs geringen Abstand zur Bildebene (4) des Objektivs aufweist.

12. Vorrichtung nach Anspruch 10 oder 11, gekennzeichnet durch die Anordnung, daß das Lichts nach der Reflektion am Objekt (1) und dem Durchgang durch das Objektiv (3) durch die Faser(n) (6,61,62) zu den Detektormitteln (10,101,102) geführt wird.

13. Vorrichtung nach einem der Ansprüche 10 bis 12, dadurch gekennzeichnet, daß die Vorrichtung Mittel zur Positionierung des Objekts (1) bezüglich der Gegenstandsebene (2) des Objektivs aufweist.

14. Vorrichtung nach einem der Ansprüche 10 bis 13, dadurch gekennzeichnet, daß die Vorrichtung eine Verstelleinrichtung (5) aufweist mit der das offene Ende der Faser(n) periodisch vertikal zur Bildebene verschoben wird und somit oszilierend verschiedene Abstände zur Bildebene aufweist.

15. Vorrichtung nach Anspruch 14, dadurch gekennzeichnet, daß die Mittel zur Bestimmung der Distanz des Objekts (1) zur Gegenstandsebene (2) Mittel zur Korrelation im Sinne einer Phasengleichrichtung zu der Oszillation der Verstelleinrichtung (5) ausweisen.

16. Vorrichtung nach einem der Ansprüche 10 bis 12, dadurch gekennzeichnet, daß zumindestens zwei Fasern (61,62) in unterschiedlicher Lage zur Bildebene des Objektivs angeordnet sind, daß mit dem reflektierten, in den beiden Fasern aufgenommenen Licht zumindestens zwei Detektormittel (101,102) beaufschlagt werden und daß die Mittel zur Bestimmung der Distanz des Objekts (1) zur Gegenstandsebene (2) eine Einrichtung zur Differenzbildung der gleichzeitig erhaltenen Intenstitätswerte umfassen.

17. Vorrichtung nach einem der Ansprüche 10 bis 16, dadurch gekennzeichnet, daß die Vorrichtung zumindestens einen Mikroprozessor zur Intensitätsauswertung und/oder zur Ansteuerung vorhandener Verstell- bzw. Positioniereinrichtungen aufweist.

18. Vorrichtung nach einem der Ansprüche 10 bis 17, dadurch gekennzeichnet, daß die Vorrichtung optische Filter (9,91,92) zur Unterdrükkung bestimmter Wellenlängen aufweist.

FIG. 1

FIG. 2A

FIG. 2B

FIG. 4

FIG. 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| X | EP-A-0 291 394 (COMMISSARIAT A L'ENERGIE ATOMIQUE) <br> * das ganze Dokument * | 1-3, 8-12,16 | G03F9/00 <br> G02B21/24 <br> G01B11/02 |
| Y | | 4,13 | |
| Y | DE-A-3 634 609 (WILD HEERBRUGG AG) <br> * das ganze Dokument * | 4,13 | |
| X | US-A-4 692 611 (L. HOOGENBOOM) <br> * das ganze Dokument * | 1-3 <br> 8-12,16 | |
| X | US-A-4 719 341 (L. HOOGENBOOM) <br> * das ganze Dokument * | 1-3 <br> 6,7, <br> 10-12 | |
| Y | PATENT ABSTRACTS OF JAPAN <br> vol. 8, no. 6 (P-247)12. Januar 1984 <br> & JP-A-58 169 007 ( NIPPON  DENKI  K.K. ) <br> 5. Oktober 1983 <br> * Zusammenfassung * | 1-7, <br> 10-15,17 | |
| Y | US-A-4 614 864 (F.Y. WU) <br><br> * das ganze Dokument * | 1-7, <br> 10-15,17 | **RECHERCHIERTE SACHGEBIETE (Int. Cl.5 )** <br><br> G03F <br> G01B <br> G02B |

Der vorliegende Recherchenbericht wurde für alle Patentansprüche erstellt

| Recherchenort | Abschlußdatum der Recherche | Prüfer |
|---|---|---|
| DEN HAAG | 13 JULI 1993 | HERYET C.D. |